Europäisches Patentamt

European Patent Office

Office européen des brevets

(11) Publication number: **0 086 671**
**B1**

(12)      **EUROPEAN PATENT SPECIFICATION**

(45) Date of publication of patent specification: **06.08.86**

(21) Application number: **83300786.7**

(22) Date of filing: **16.02.83**

(51) Int. Cl.⁴: **H 03 K 17/22,** H 03 K 3/356,
G 01 R 19/165

(54) **Source voltage build-up detecting circuit.**

(30) Priority: **16.02.82 JP 23309/82**

(43) Date of publication of application:
**24.08.83 Bulletin 83/34**

(45) Publication of the grant of the patent:
**06.08.86 Bulletin 86/32**

(84) Designated Contracting States:
**DE FR GB**

(56) References cited:
**DE-A-2 600 197**
**GB-A-2 059 707**
**US-A-4 173 756**
**US-A-4 196 362**
**US-A-4 300 065**

**PATENTS ABSTRACTS OF JAPAN, vol. 3, no.**
. **82, 14th July 1979, page 75 E 123**

(73) Proprietor: **FUJITSU LIMITED**
**1015, Kamikodanaka Nakahara-ku**
**Kawasaki-shi Kanagawa 211 (JP)**

(72) Inventor: **Nakamori, Tutomu**
**Dai-3 Akiyama-so 202 868 Kamikodanaka**
**Nakahara-ku Kawasaki-shi Kanagawa 211 (JP)**

(74) Representative: **George, Sidney Arthur et al**
**GILL JENNINGS & EVERY 53-64 Chancery Lane**
**London WC2A 1HN (GB)**

Courier Press, Leamington Spa, England.

EP 0 086 671 B1

## Description

This invention relates to a voltage detecting circuit, and particularly to a circuit for detecting the build-up of a power source voltage and which is used when an internal circuit is automatically reset at the time of switching on the power source.

When electronic equipment is operated, functional blocks constituting the electronic equipment are first reset in an initial state and then operate normally. Accordingly, each functional block is provided with a signal input terminal for resetting an internal circuit within a certain time after the power source voltage reaches a predetermined level, and, furthermore, a circuit for detecting the build-up of the power source voltage is arranged in each functional block so as to emit reset pulses before the power source voltage reaches the predetermined level. An integrated circuit comprising a capacitor and a resistor is often utilised as a power source voltage build-up detecting circuit of this type.

Recently, with the development of the integrated circuit, this type of power source voltage build-up detecting circuit has been built into the integrated circuit, and thus the integrated circuit, per se, is automatically reset. This technique is generally adopted in microprocessors which are used in various fields, and various modes are available for the power source voltage build-up detecting circuit. Usually, however, a mode is adopted in which the output of a series circuit comprising a capacitor, a resistor, and a metal-oxide semiconductor (MOS) transistor is amplified by using an inverter stage.

However, in the above-mentioned circuit, the threshold voltage of the transistor is, in practice, 0.8V, and therefore the output voltage of the circuit is only 1.6V, at the highest. As a result, the level of the circuit is low, and operation of the functional blocks cannot be guaranteed. This is a problem in the conventional technique.

An object of the present invention is to provide a circuit for detecting the build-up of the power source voltage, in which erroneous operation of the circuit is appreciably reduced.

According to the invention there is provided a source voltage build-up detecting circuit which detects, after the source is switched on, whether the source voltage between a high potential line and a low potential line is higher than a predetermined voltage and outputs a detecting signal, comprising a level shifting element which is connected to the high potential line and supplies a voltage lower than the source voltage to a complementary metal oxide semiconductor (CMOS) inverter as a working voltage, the inverter comprising a first P channel transistor and a first N channel transistor which are connected in series between the level shifting element and the low potential line, the gates of the transistors being connected together; a second P channel transistor and a second N channel transistor which are connected in series between the high potential line and the low potential line, the series connection point between these transistors providing the output node of the detecting circuit, and the gates of these transistors being connected to a series connection point between the first P channel transistor and the first N channel transistor; and a voltage generating circuit which is connected between the high potential line and the low potential line, the output voltage of the voltage generating circuit being supplied to the gates of the first P channel transistor and the first N channel transistor to supply thereto, when the source voltage is lower than the predetermined voltage after the source voltage is switched on, a voltage which is higher than the threshold voltage of the CMOS inverter, and when the source voltage becomes higher than the predetermined voltage, a voltage which is lower than the threshold voltage of the CMOS inverter, whereby when the source voltage reaches the predetermined value, the output of the CMOS inverter is inverted.

An embodiment of the invention will now be described by way of example, with reference to the accompanying drawings, in which:

Figure 1 is a circuit diagram of a prior art circuit for detecting the build-up of the power source voltage;

Figure 2 is a time chart showing the voltage changes at respective points in the circuit shown in Figure 1;

Figure 3 is a circuit diagram of a circuit according to the present invention for detecting the build-up of the power source voltage;

Figure 4 is a time chart showing voltage changes at respective points in the circuit shown in Fig. 3;

Figure 5 is a block diagram showing practical utilisation of the present invention;

Figure 6 is an example of a frequency divider circuit shown in Fig. 5; and

Figure 7 is a time chart showing voltage changes at respective points in the circuits shown in Figs. 5 and 6.

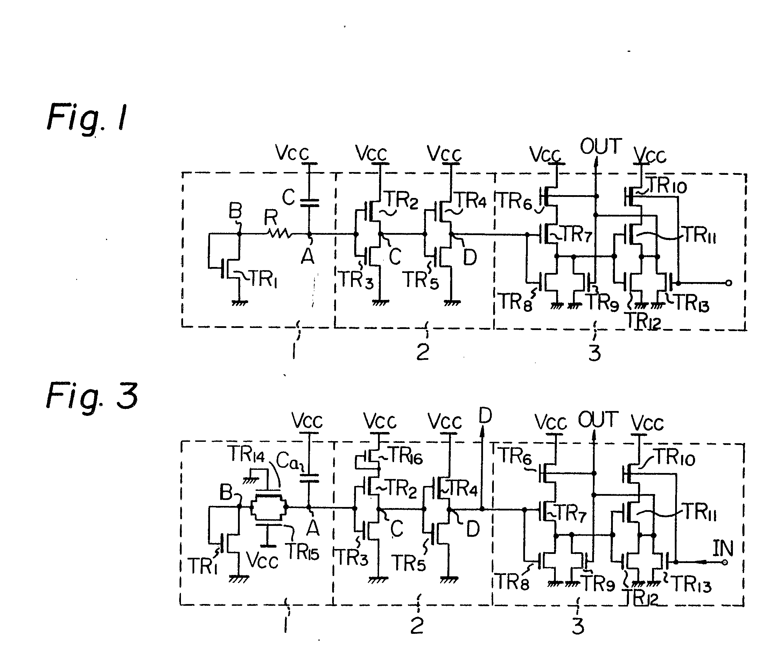

A typical prior art circuit for detecting the build-up of a power source voltage is shown in Fig. 1. This circuit comprises a series circuit 1 consisting of a capcitor C, a resistor R and an N-channel MOS transistor TR1; an amplifying stage 2 consisting of two CMOS inverter stages; and an output stage 3 comprising a NOR flip-flop circuit. In Fig. 1, for simplification P-channel MOS transistors are indicated by a thick solid line.

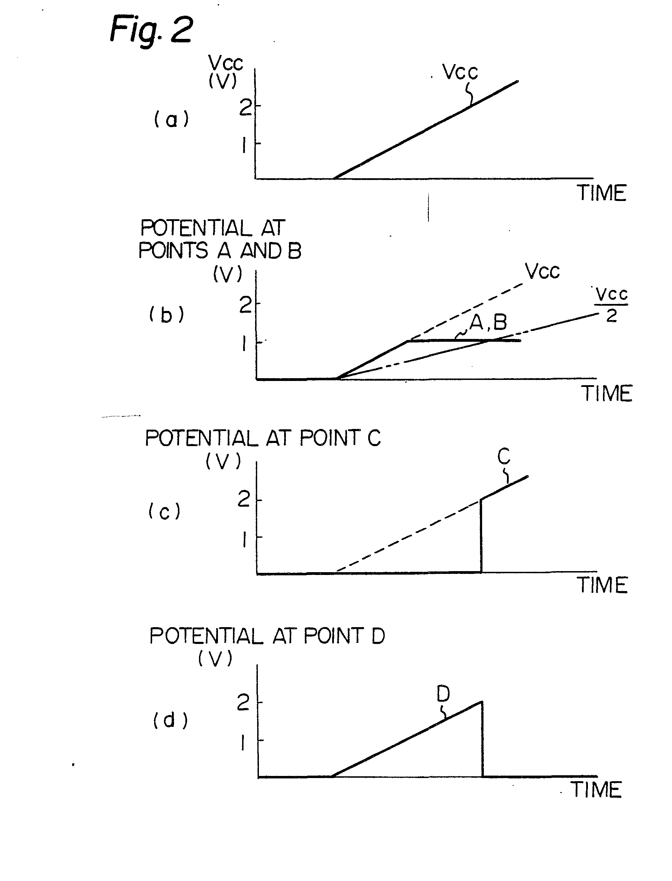

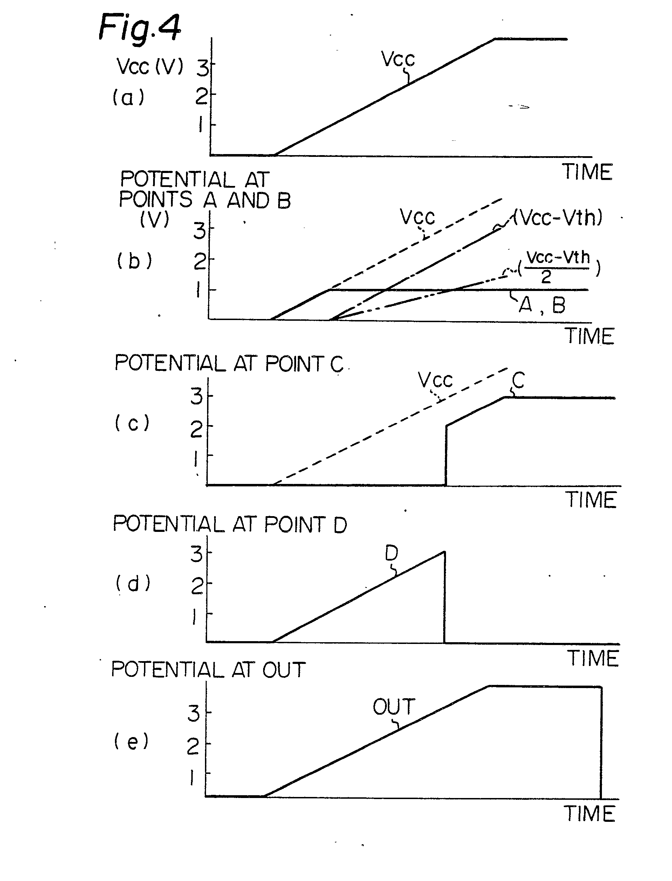

The operation of this circuit will now be described with reference to Fig. 2. When the power source voltage $V_{cc}$ to be applied to the entire system, which includes this circuit, gradually increases, as is shown in Fig. 2(a), build-up of the voltage level at a point A (Fig. 1) through the capacitor C, as is shown in Fig. 2(b), results. Also, the voltage at a point B rises together with the voltage at the point A, but the voltage at the point B is clamped so that it is equal to the threshold voltage (about 1V) of the transistor TR1. Since the CMOS inverter comprising the maintained in the on state P-channel transistor TR2 and the N-channel transistor TR3 has a threshold voltage of $V_{cc}/2$, the transistor TR3 is on until the $V_{cc}/2$ line reaches the clamped level at points A and B. Then, the transistor TR2 is turned on, and the output at a point C follows the build-up on the power source voltage $V_{cc}$, as is shown in Fig. 2(e). The transistor TR5 is turned on due to the build-up of the output at the point C, whilst the output at a point D drops, as is shown in Fig. 2(d).

In the above-described circuit, since the voltage at the point A is clamped to about 1V, the output at the point D is 2V at the highest. Incidentally, since the threshold voltage of the transistor TR1 is, in practice, only 0.8V, the output at point D in fact reaches only 1.6V. Since the level of the output at the point D is relatively low, operation of the flip-flop circuit 3 cannot be guaranteed. This is a problem involved in the conventional technique.

This problem can be solved only by raising the clamped voltage at the point A, and elevation of the clamped voltage at the point A can only be achieved by increasing the threshold voltage of the transistor TR1. However, since the voltage at the point A is maintained even after the power source voltage is stabilised, if the voltage at the point A is increased, both the P-channel and N-channel transistors of the CMOS inverter are turned on and, therefore, a direct current flows.

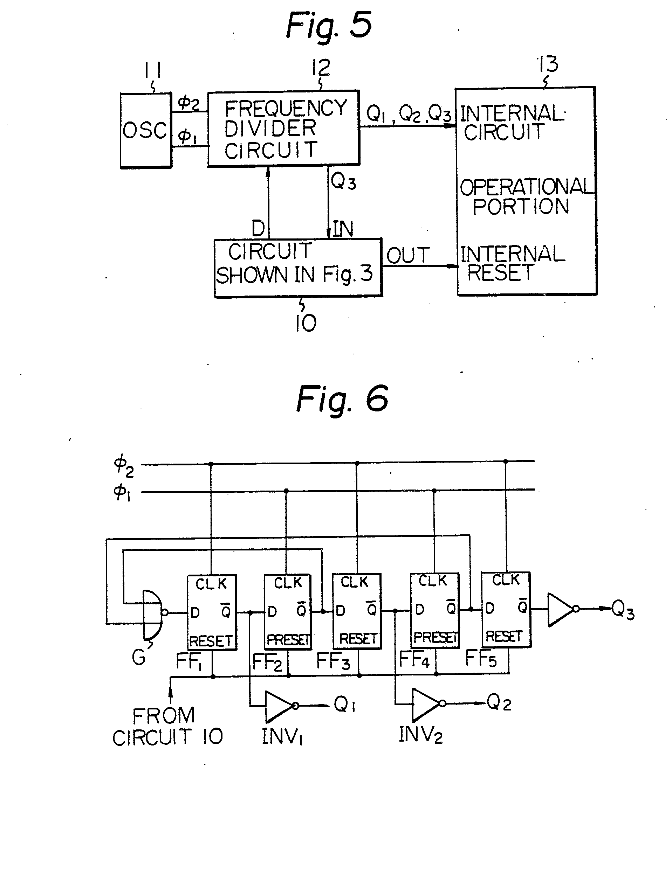

Figure 3 is a circuit diagram of a circuit according to the present invention for detecting the build-up of the power source voltage. In Fig. 3, the output of the inverter stages 2 can be increased witout elevation of the clamped voltage of the series circuit 1 shown in Fig. 1.

In Fig. 3, the same reference numerals as those used in Fig. 1 represent the same members as in Fig. 1. In this embodiment, a P-channel transistor TR16 used as the level shifting element is connected in series between the $V_{cc}$ terminal and the P-channel transistor TR2 of the CMOS inverter in the input stage of the inverter 2. A resistive element formed by MOS transistors TR14 and TR15 can be used in place of the pure resistor shown in Fig. 1.

The operation of the circuit of this embodiment will now be described with reference to Fig. 4. Due to the build-up of the power source voltage $V_{cc}$, the voltage at the point A is elevated, as is shown in Fig. 4(a). Due to use of the transistor TR16, the voltage between the terminals of the transistors TR2 and TR3 is adjusted to $(V_{cc}—V_{th})$, as is shown in Fig. 4(b). $V_{th}$ represents the threshold voltage (in practice 0.8V) of the transistor TR16. Accordingly, the threshold value of the CMOS inverter for the transistors TR2 and TR6 is $(V_{cc}—V_{th})/2$, as is shown in Fig. 4(b). Since the voltage at the points A and B is maintained at the level clamped by the transistor TR1 (about 1V), the transistor TR3 is turned on before the voltage intersects the $(V_{cc}—V_{th})/2$ line, and the output is equal to the ground voltage, as is shown in Fig. 4(c), and when the value of $(V_{cc}—V_{th})/2$ is increased beyond the voltage at the point B, the transistor TR2 is turned on. By turning on the transistor TR2, the output at the point D is reduced from about 3V (experimentally. 2.6 to 2.4V) to the ground voltage, as is shown in Fig. 4(d).

In the above-described embodiment, the P-channel transistor TR16 is used as the threshold level shifting element, but another element, such as a diode or a Schottky diode, may be used instead of the transistor TR16. Furthermore, a plurality of level shifting elements may be used. Incidentally, if the output at the point D falls after the power source voltage $V_{cc}$ reaches a predetermined level, there is the risk of elevation of the lower limit of the power source voltage range where the element as a whole can be operated.

When the output at the point D is in a conductive state, the transistor TR8 is also in a conductive state, the transistors TR6 and TR7 are in the off state, and a voltage equal to the power source voltate $V_{cc}$ appears at the output terminal OUT. When a positive pulse is applied to the gate of the transistor TR13, the transistor TR13 is turned on and the output OUT falls to the ground level, as is shown in Fig. 4(e).

Figure 5 is a block diagram showing use of the present invention in the control of a frequency divider circuit. In Fig. 5, a frequency divider circuit 12 divides the output of an oscillator 11, and the divided output is supplied to an internal circuit of an operational portion 13. A circuit 10 of the present invention is used so as to reset the frequency divider circuit 12 automatically when the power source voltage is switched on.

Figure 6 is an example of the frequency divider circuit 12 shown in Fig. 5. The circuit shown in Fig. 6 comprises flip-flop circuits $FF_1$, $FF_2$, $FF_3$, $FF_4$, and $FF_5$ which receive clock pulses $\varphi_1$ and $\varphi_2$ alternately. The $\overline{Q}$ outputs of the flip-flop circuits $FF_2$ and $FF_4$ are fed back via a gate G to the D input of the flip-flop circuit $FF_1$. $\overline{Q}$ outputs of the flip-flop circuits, $FF_1$, $FF_3$ and $FF_5$ are fed via inverters $INV_1$, $INV_2$ and $INV_3$, respectively, to the internal circuit of the operational circuit 13, and the $\overline{Q}$ output of the flip-flop circuit $FF_5$ is fed via the inverter $INV_3$ to the input terminal of the circuit 10 shown in Fig. 5. In Fig. 6, it should be noted that the signal corresponding to the potential at the point D in Fig. 4(d) is supplied to the flip-flop circuits $FF_1$ to $FF_5$ as a reset signal or a preset signal alternately.

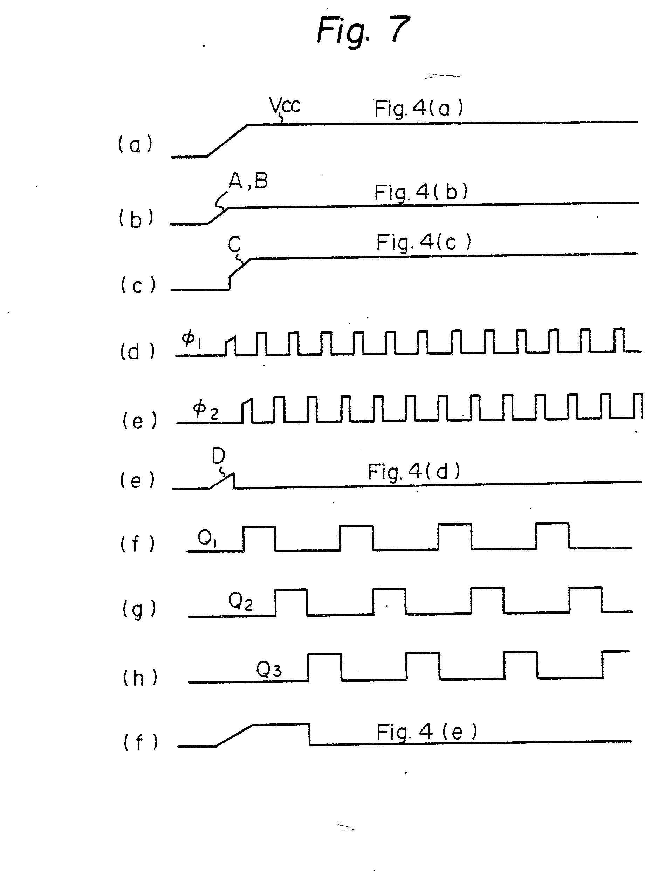

Figure 7 is a time chart showing the operation of the circuits shown in Figs. 5 and 6. In Fig. 7, (a), (b), (c), (e) and (f) correspond respectively to Fig. 4(a), (b), (c), (d), (e) on a different scale. When the signal shown in Fig. 7(e) is supplied to the frequency divider circuit 12, the initial states of the flip-flop circuits $FF_1$ to $FF_5$ are set, and the flip-flop circuits $FF_1$, $FF_3$ and $FF_5$ supply outputs $Q_1$, $Q_2$ and $Q_3$ to the internal circuit of the operational portion 13. Also, the output $Q_3$ is fed to the circuit 10 so as to reset the output shown in Fig. 7(f). The signal shown in Fig. 7(f) is supplied to the operational portion 13 as an internal reset signal.

As is apparent from the foregoing description, since the level shifting element is inserted into the lead of the first inverter stage of the power source voltage build-up detecting circuit in the present invention, the build-up of the output of the inverter can be delayed, and the output of the second inverter stage can be reduced sharply from the desired relatively high level to the ground voltage. Accordingly, the output of the power source voltage build-up detecting circuit can be made more reliable.

## Claims

1. A source voltage build-up detecting circuit which detects, after the source is switched on, whether the source voltage ($V_{cc}$) between a high potential line and a low potential line is higher than a predetermined voltage and outputs a detecting signal, comprising a level shifting element (TR16) which is conected to the high potential line ($V_{cc}$) and supplies a voltage lower than the source voltage to a complementary metal oxide semiconductor (CMOS) inverter as a working voltage, the inverter comprising a first P channel transistor ($TR_2$) and a first N channel transistor ($TR_3$) which are connected in series between the level shifting element (TR16) and the low potential line, the gates of the transistors being connected together; a second P channel transistor ($TR_4$) and a second N channel transistor ($TR_5$) which are connected in series between the high potential line and the low potential line, the series connection point between these transistors providing the output node (D) of the detecting circuit, and the gates of these transistors being connected to a series connection point (C) between the first P channel transistor and the first N channel transistor; and a voltage generating circuit (Ca, $TR_{14}$, $TR_{15}$, $TR_1$) which is connected between the high potential line and the low potential line, the output voltage of the voltage generating circuit being supplied to the gates of the first P channel transistor and the first N channel transistor to supply thereto, when the source voltage is lower than the predetermined voltage after the source voltage is switched on, a voltage which is higher than the threshold voltage of the CMOS inverter, and when the source voltage becomes higher than the predetermined voltage, a voltage which is lower than the threshold voltage of the CMOS inverter, whereby when the source voltage reaches the predetermined value, the output of the CMOS inverter is inverted.

2. A circuit according to claim 1, characterised in that the level shifting element comprises a P-channel MOS transistor (TR6).

3. A circuit according to claim 1, characterised in that the level of shifting element comprises a diode.

4. A circuit according to claim 1, characterised in that the level of shifting element comprises a Schottky diode.

5. A circuit according to any preceding claim, characterised in that the voltage generating circuit comprises a capacitor (Ca) to one end of which the source voltage ($V_{cc}$) is applied, resistance means ($TR_{14}$, $TR_{15}$) having one end connected to the other end of the capacitor, and a transistor ($TR_1$) having a gate and a drain both connected to the other end of the resistance means and a source connected to ground; and in that the junction between the capacitor and the resistance means is connected to the input of the CMOS transistor ($TR_2$).

## Patentansprüche

1. Quellspannungsanstiegsdetektor, welcher, nachdem die Quelle eingeschaltet worden ist, feststellt, ob die Quellspannung ($V_{cc}$) zwischen einer Hochpotentialleitung und einer Niedrigpotentialleitung höher als eine vorbestimmte Spannung ist, und ein Detektorsignal abgibt, mit einem Pegelschiebeelement (TR16), welches mit der Hochpotentialleitung ($V_{cc}$) verbunden ist und eine Spannung, die niedriger als die Quellspannung ist, als Arbeitsspannung an einen komplementären Metalloxidhalbleiter—(CMOS)—Inverter liefert, welcher einen ersten P-Kanal-Transistor ($TR_2$) und einen ersten N-Kanal-Transistor ($TR_3$) umfaßt, die in Reihe zwischen dem Pegelschiebeelement ($TR_{16}$) und der Niedrigpotentialleitung angeschlossen sind, wobei die Gates der Transistoren miteinander verbunden sind; mit einem zweiten P-Kanal-Transistor ($TR_4$) und einem zweiten N-Kanal-Transistor ($TR_5$), die in Reihe zwischen der Hochpotentialleitung und der Niedrigpotentialleitung angeschlossen sind, wobei der Reihenverbindungspunkt zwischen diesen Transistoren den Ausgangsknoten (D) der Detektorschaltung bildet und die Gates dieser Transistoren mit einem Reihenverbindungspunkt (C) zwischen dem ersten P-Kanal-Transistor und dem ersten N-Kanal-Transistor verbunden sind; und mit einer Spannungsgeneratorschaltung (Ca, $TR_{14}$, $TR_{15}$, $TR_1$), die zwischen der Hochpotentialleitung und der Niedrigpotentialleitung angeschlossen ist, wobei die Ausgangsspannung der Spannungsgeneratorschaltung den Gates des ersten P-Kanal-Transistors und des ersten N-Kanal-Transistors zugeführt wird, um diesen dann, wenn nach Einschalten der Quellspannung die Quellspannung niedriger als die vorgestimmte Spannung ist, eine Spannung zuzuführen, welche höher als die Schwellenwertspannung des CMOS-Inverters ist, und dann, wenn die Quellspannung höher als die vorbestimmte Spannung wird, eine Spannung zuzuführen, die niedriger als die Schwellenwertspannung des CMOS-Inverters ist, wodurch dann, wenn die Quellspannung den vorbestimmten Wert erreicht, der Ausgang des CMOS-Inverters invertiert wird.

2. Schaltung nach Anspruch 1, dadurch gekennzeichnet, daß das Pegelschiebeelement einen P-Kanal-MOS-Transistor (TR6) unfaßt.

3. Schaltung nach Anspruch 1, dadurch gekennzeichnet, daß das Pegelschiebeelement eine Diode umfaßt.

4. Schaltung nach Anspruch 1, dadurch gekennzeichnet, daß das Pegelschiebeelement eine Schottky-Diode umfaßt.

5. Schaltung nach einem der vorhergehenden Ansprüche, dadurch gekennzeichnet, daß die Spannungsgeneratorschaltung einen Kondensator (Ca) umfaßt, dessen einem Ende die Quellspannung ($V_{cc}$) zugeführt wird, und Widerstandseinrichtungen ($TR_{14}$, $T_{15}$), von denen ein Ende mit dem anderen Ende des Kondensators verbunden ist, und einen Transistor ($TR_1$), der ein Gate und ein Drain hat, die beide mit dem anderen Ende der Widerstandseinrichtungen verbunden sind, und eine Source, die mit Erde verbunden ist; und daß der Verbindungspunkt zwischen dem Kondensator und den Winderstandseinrichtungen mit dem Eingang des CMOS-Transistors ($TR_2$) verbunden ist.

**Revendications**

1. Circuit détecteur de montée de la tension d'alimentation, qui détecte, après que la source d'alimentation a été mise en circuit, si la tension d'alimentation ($V_{cc}$) entre une ligne à potentiel élévé et une ligne à potentiel bas est supérieure à une tension prédéterminée et qui délivre à sa sortie un signal de détection, comprenant un élément de décalage de niveau ($TR_{16}$) connecté à la ligne à potential élevé ($V_{cc}$) et fournissant une tension inférieure à la tension d'alimentation à un inverseur métal-oxyde-semiconducteur complémentaire (CMOS) en tant que tension de travail, l'inverseur comprenant un premier transistor à canal P ($TR_2$) et un premier transistor à canal N ($TR_3$) qui sont connectés en série entre l'élément de décalage de niveau ($TR_{16}$) et la ligne à potentiel bas, les grilles des transistors étant connectées l'une à l'autre; un second transistor à canal P ($TR_4$) et un second transistor à canal N ($TR_5$) qui sont connectés en série entre la ligne à potentiel élévé et la ligne à potentiel bas, le point de connexion en série entre ces transistors consituant le noeud de sortie (D) du circuit détecteur et les grilles de ces transistors étant connectées à un point de connexion en série (C) entre le premier transistor à canal P et le premier transistor à canal N; de même qu'un circuit générateur de tension (Ca, $TR_{14}$, $TR_{15}$, $TR_1$) qui est connecté entre la ligne à potentiel élevé et la ligne à potentiel bas, la tension de sortie du canal générateur de tension étant appliquée aux grilles du premier transistor à canal P et du premier transistor à canal N afin de leur fournir, lorsque la tension d'alimentation est inférieure à la tension prédéterminée, après l'application de la tension d'alimentation, une tension qui est plus élevée que la tension de seuil de l'inverseur CMOS et, lorsque la tension d'alimentation devient supérieure à la tension prédéterminée, une tension qui est plus basse que la tension de seuil de l'inverseur CMOS, de sotie que le signal de sortie de l'inverseur CMOS est inversé quand la tension d'alimentation atteint la valeur prédéterminée.

2. Circuit selon la revendication 1, caractérisé en ce que l'élément de décalage de niveau est constitué par un transistor MOS à canal P ($TR_{16}$).

3. Circuit selon la revendication 1, caractérisé en ce que l'élément de décalage de niveau est constitué par une diode.

4. Circuit selon la revendication 1, caractérisé en ce que l'élément de décalage de niveau est constitué par une diode à barrière de Schottky.

5. Circuit selon l'une quelconque des revendications précédentes, caractérisé en ce que le circuit générateur de tension comprend un condensateur (Ca), à l'une des bornes duquel est appliquée la tension d'alimentation ($V_{cc}$), un dispositif de résistance ($TR_{14}$, $TR_{15}$), connecté par une borne à l'autre borne du condensateur; ainsi qu'un transistor ($TR_1$) possédant une grille et un drain connectés tous deux à l'autre borne du dispositif de résistance et une source connectée à la masse; et en ce que la jonction entre le condensateur et le dispositif de résistance est reliée à l'entrée du transistor CMOS ($TR_2$).

Fig. 1

Fig. 3

0 086 671

# Fig. 2

(a)

Vcc (V) / TIME — Vcc

(b) POTENTIAL AT POINTS A AND B

(V) / TIME — Vcc, Vcc/2, A,B

(c) POTENTIAL AT POINT C

(V) / TIME — C

(d) POTENTIAL AT POINT D

(V) / TIME — D

2

# Fig.4

(a) Vcc (V) — Vcc vs TIME

(b) POTENTIAL AT POINTS A AND B (V) — $V_{cc}$, $(V_{cc}-V_{th})$, $\left(\frac{V_{cc}-V_{th}}{2}\right)$, A,B vs TIME

(c) POTENTIAL AT POINT C — $V_{cc}$, C vs TIME

(d) POTENTIAL AT POINT D — D vs TIME

(e) POTENTIAL AT OUT — OUT vs TIME

3

# Fig. 5

# Fig. 6

# Fig. 7